(19) Europäisches Patentamt

European Patent Office

Office européen des brevets

(11) **EP 1 061 652 A2**

(12) **EUROPEAN PATENT APPLICATION**

(43) Date of publication:
20.12.2000 Bulletin 2000/51

(51) Int. Cl.⁷: $H03M\ 1/10$

(21) Application number: 00112502.0

(22) Date of filing: 13.06.2000

(84) Designated Contracting States:
**AT BE CH CY DE DK ES FI FR GB GR IE IT LI LU MC NL PT SE**
Designated Extension States:
**AL LT LV MK RO SI**

(30) Priority: **14.06.1999 IT MI991315**

(71) Applicant:
**Siemens Information and Communication Networks S.p.A.
20126 Milano (IT)**

(72) Inventors:
• **Gatti, Umberto**
 **27100 Pavia (IT)**
• **Maloberti, Franco**
 **27020 Torre d'Isola (PV) (IT)**
• **Rallo, Claudio**
 **92100 Agrigento (IT)**

(74) Representative: **Giustini, Delio
 c/o Siemens Information and Communication Networks S.p.A.,
 Cascina Castelletto
 20019 Settimo Milanese (IT)**

(54) **Linearization procedure of the transfer characteristic of analog-to-digital converters and relevant circuit**

(57)  Linearization procedure of the transfer non-linear characteristic of an analog-to-digital converter commonly available on the market and relevant circuit. According to a first embodiment, we operate on two analog-to-digital converters assumed to be similar, employing in the calibration phase a generic signal at the input of both, directly to the first converter and attenuated to the second one, and collecting a minimum number of appropriate digital samples at their outputs. The subsequent processing of the above-mentioned samples through a processor enables to determine the transfer inverse non-linear characteristic of the converter. According to a first solution, a processor enables to "apply" in real time the inverse transfer characteristic determined at the digital outputs of the converter in the on-line operation. Or, in a second solution, this last can be written in a mapping memory, placed downstream one of the converters, in the on-line operation it allows to correct original non-linearities. A second online memory enables the adaptive operation.

Fig. 3

EP 1 061 652 A2

**Description**

Field of the invention

The present invention relates to the field of conversion of electrical signals in digital form and more in particular to a linearization procedure of the transfer characteristic of an analog-to-digital converter and relevant circuit.

Background art

Several parameters feature the correct operation of an analog-to-digital converter; among these, the most significant ones are undoubtedly:

- the resolution, which is the minimum value of the input signal, that the converter can discriminate;
- the maximum conversion speed, that is, the maximum sampling frequency allowed by specifications, limiting the band width of the signal to be processed;
- the maximum band width of the input signal, limiting the minimum sampling frequency;
- the maximum dynamic range of the input signal, and finally
- the signal-noise (S/N) ratio at output, determined by the quantization noise, by the jitter of the sampling clock, and by a parameter known as SFDR (Spurious Free Dynamic Range) indicating the value in dBFS (dB Full Scale) of the ratio between the amplitude of the input fundamental and the amplitude of the maximum value harmonic.

This last parameter (SFDR) indicates the linearity degree of the converter transfer characteristic and assumes great importance in applications where great linearity is requested, such as for instance in the mobile telecommunication field, of special competence of the applicant. Recent developments in this sector foresee in fact the realization of a broad band digital receiver which due to the particular architecture adopted, requires that all the components of the whole conversion/ amplification chain have a highly linear transfer characteristic. Therefore, it is essential that the A/D converter, on his side, does not introduce significant distortions. In this context, the requirements relevant to the SFDR requested by the A/D converter to satisfy the specific GSM 900 MHz and DCS 1800 MHz result being around 95 and 100 dBFS.

An A/D converter capable to meet the above mentioned requirements lies outside those commonly found on the market, mainly due to the difficulty to conjugate, at limited costs, high operation speeds, input broad band and best linearity; requirements these that must be jointly present in an A/D converter suitable for use in the above mentioned receiver. On the other hand, the ad hoc realization of a converter having similar characteristics would involve considerable difficulties and costs, so that the most convenient way is to fall back on the best commercial devices capable to satisfy the speed and input band requirements, searching in the meantime some correction/linearization technique of the characteristic that makes SFDR parameter fall within the desired limits.

A first known technique aiming at reaching this target is described, for instance, in the article "Linearization of Analog-to-Digital Converters", by A. C. Dent and Colin F. N. Cowan, published on IEEE Transactions on Circuits and Systems, Vol. 37, N. 6, June 1990, pages 729-737.

The technique described in the above mentioned paper consists in employing statistical tools to go back to the real transfer characteristic of the N bit A/D converter under examination, to the purpose of availing of the information obtained to generate a new transfer characteristic that better approximates to the ideal one. The statistical method employed foresees to send to the input of the A/D converter an appropriate training signal having a known probability distribution of amplitude, for instance, a sinusoid. The converter, due to its non-linear transfer characteristic, distorts the known probability distribution according to a method that can be determined from the direct observation of the outgoing N bit digital codes. In fact, it is possible to group the latter in an histogram of the distribution of occurrence of the codes themselves, having the above mentioned codes on the x-axis, and the relevant frequency according to which the same codes show at output, on the y-axis. The so-called "Code Density" method is applied to the histogram thus obtained, enabling to determine the most probable threshold levels, the whole of which forms the actual transfer characteristic of the converter. This last method is described for instance in the following articles:

- "Dynamic Testing and Diagnostic of A/D Converters", by M. Vanden Bossche, J. Schouckens and J. Renneboog, published on IEEE Trans. CAS, Vol. 33, N. 8, August 1986, pages 775-785.
- "Full Speed Testing of A/D Converters", by J. Doernberg, H. S. Lee, D. A. Hodges, published on IEEE J. Solid-State Circuits, Vol. SC-19, Dec. 1984, pages 820-827.

Once the most probable threshold levels are acquired, through a correction algorithm called "Threshold Tracking" the value of the maximum allowed deviation between the points of the real and ideal characteristic is defined, above which, the N bit code outgoing from the A/D converter is replaced by a new code, it too having N bits, belonging to the ideal characteristic. The characteristic so obtained is therefore more close to the ideal one as a whole. The "Threshold Tracking" algorithm is briefly described in the first paper mentioned (see Fig. 10), and is described in detail in the paper by A. C. Dent and Colin F. N. Cowan, under the title "High Resolution Analogue to Digital Conversion for Telecommunications", published on IEEE Coll. Dig. N. 1987/92, Nov. 1987, pages 2/1-2/5. In conclusion, the "Threshold Tracking" algorithm allows to make a mapping operation of the aggregate of N bit generated by the A/D converter whose characteristic is to be linearized, within a new group of N bit codes of a linearized characteristic, which is written in a random access non volatile memory, employed on-line downstream the converter as a Look-Up-Table (LUT) to generate correct codes coinciding with the codes to be corrected, used as reading addresses of the memory itself. Making reference to the first article mentioned, it is highlighted the difficulty to generate training signals very similar to the ideal waveforms, to which the known probability distributions are associated. An alternative procedure therein proposed, which would result free from said drawback, is to employ in parallel to the first A/D converter a second A/D converter having the same number N of bits, but more accurate than that to linearize, in order to directly obtain the correct probability distribution associated to the training signal.

A second known technique for the linearization of the characteristic of an A/D converter available on the market, representing an evolution of the one previously described, is described in the article under the title "Improving the Linearity in High-Speed Analog-to-Digital Converters" by U. Gatti, G. Gazzoli and F. Maloberti, published on Proc. IEEE int. Symposium on Circuits and Systems, 1998, pages I/17-I/20.

The technique described in the mentioned paper, consists once again in employing statistical methods to go back to the real transfer characteristic of the A/D converter under examination, in order to generate a new characteristic better approximating the ideal one. As in the case of the article by A. C. Dent and Colin Cowan mentioned above, the statistical method, defined "off-line", foresees to send a training sinusoidal signal at the converter input, to observe the outgoing N bit codes, to group these last in an histogram of the distribution occurrence of the codes themselves and determine the most probable threshold levels, the whole of which forms the real transfer characteristic of the converter. However, this last phase shows a variant, described in article "ADC Characterization Using the Code Density Test Method with Deterministic Sampling", by V. Liberali, F. Maloberti, M. Stramesi published on Proc. 2nd International Mixed Signal Testing Workshop, Quebec City, May 1996, pp. 113-118. According to what indicated in the previous article, the sinusoidal training signal has a constant phase shifting compared to the clock signal timing the A/D converter. This measure shows two advantages: it enables to considerably reduce the number of samples of the training signal to acquire, in order to determine the thresholds of the N bit converter to linearize and to show these last with accuracy higher than the N bit resolution of the converter, that is with M+N bit words. The determination of the minimum M of additional bits depends of course on the accuracy degree one intends to reach, and therefore on the specific requests for the SFDR parameter. In this way it is possible to determine with higher accuracy the real transfer characteristic of the converter and generate a correspondence table (LUT) between the N bit original codes and the M+N bit corrected codes. These last are written in a mapping non-volatile memory at the address specified by the N bit codes. On completion of the calibration phase, the mapping memory is placed on-line downstream the converter, and addressed as said before.

In another embodiment, defined "on-line", a second A/D M+N bit converter is used in parallel to the first one having N bit, more slow and accurate than the latter, to directly generate the M+N bit corrected codes, to be written in the mapping non-volatile memory, and obtained applying an actual signal (non training signal). A second memory on-line enables the adaptive operation. A brief description of this embodiment can be found in the paper mentioned above, while a higher detail degree can be found in the patent "Linearization Procedure of the Transfer characteristic of an Analog-to-digital converter and Relevant Circuit" under the name of U. Gatti and G. Gazzoli, application No. MI98A-000630, 26/3/1998, together with its possible circuit implementation.

Drawbacks of the background art

Employing the first linearization technique mentioned above (make reference to the paper by A. C. Dent and Colin Cowan), it is possible to linearize the transfer characteristic of an A/D converter, making a minimum error equal in absolute value to the least significant bit (Least Significant Bit, LSB) of the digital code generated by the converter itself. This is expressly declared in the above mentioned articles, and appears obvious from the observation that the number of bits, N, of the two characteristics, before and after the linearization, remains identical. It results a non-acceptable residual non-linearity for the particular recent applications highlighted in the mobile field, that make the above mentioned techniques completely inapplicable. In the mentioned background art, the acquisition of information necessary to perform the linearization takes place in an initial phase that results separate, compared to the continuous operation of the converter. Therefore, it results impossible to conciliate the continuous operation with this calibration phase, since to acquire the above-mentioned information it is necessary to send the A/D converter a training signal, rather than the actual signal. This remark results always true also using a second and more accurate A/D converter in parallel to the first one, since it is not used on-line, but only in the starting calibration phase in association with the training signal. The resulting drawback is that to be unable to compensate in real time additional deviations from linearity that inevitably occur during the device life cycle, for instance due to aging or thermal drift.

Employing the second linearization technique mentioned above (refer to the article by U. Gatti, G. Gazzoli and F. Maloberti), it is possible to correct the transfer characteristic of an N bit A/D converter, making a minimum error equal in absolute value to a least significant bit of the M+N bit digital code. In the first "off-line" embodiment, through acquiring a significant betterment of performances versus the method of A. C. Dent and Colin Cowan, the acquisition of the information necessary to perform the linearization takes place in an initial phase that results disassociated compared to the continuous operation of the converter. Therefore it is impossible to conciliate the continuous operation with this calibration phase, since to acquire the above-mentioned information it is necessary to send the A/D converter a training signal, rather than the actual signal. The deriving drawback is that not to be able to compensate in real time additional deviations from linearity that inevitably occur during the life cycle of the device. In the second "on-line" embodiment this drawback is overcome, thanks to an adaptive operation based on the actual input signal. However, the circuit implementation involves the availability of a track&hold circuit, with operation speed equals to those of the A/D converter to linearize and linearity such to meet the particular recent applications highlighted in the mobile sector. A component satisfying these requirements is not presently available on the market, but it must be purposely implemented through an integrated circuit or with discrete components. Moreover, the presence of skew among the paths of the clock governing the first converter and that (obtained by division from the first one) governing the second A/D could be the cause for degradation of non-linearity, not assuring a simultaneous sampling.

Object and summary of the invention

Therefore object of the present invention is to overcome the above mentioned drawbacks and find a linearization procedure of the transfer characteristic of an analog-to-digital converter of the adaptive type that can be implemented without generation of appropriate training signals and through a less complex and expensive hardware architecture even in the case of an "on-line" implementation.

The procedure of the invention, in its different embodiments, articulates through a number of operations, which can be separately qualified as follows:

a) acquisition of first and second N bit digital words coming out from two A/D converters, supposed to be equal, coinciding with a same set of input analog values, directly sent to the first converter and attenuated by a factor 1/K (K > 1) to the second one;
b) determination of third digital words representing the M+N bit (M>0) polynomial coefficients capable to unambiguously define the inverse transfer characteristic of the converter;
c) "application" in real time of the inverse transfer characteristic to original first words coming out from the A/D converter;
d) as an alternative to point c), generation of a bi-univocal correspondence table between the first M+N bit digital words and fourth digital words, more capable to represent the set of input analog values, through the polynomial coefficients determined under point b);
e) on-line reading of this table addressed by original words coming out from the first converter A/D; or:
f) as an alternative to point a), acquisition of first and second N bit digital words coming out from two A/D converters of the same type, but having transfer characteristics supposed to be different, coinciding with a same set of input analogue values;
g) determination of third digital words representing the M+N bit (M>0) polynomial coefficients capable of unambiguously define the deviation between the transfer characteristic of the first converter and that of the second one;
h) generation of a bi-univocal correspondence table between the second and fourth M+N bit digital words, through the polynomial coefficients determined under point g), to be placed downstream the second converter so to render equal the fourth digital words and the first digital words (represented at M+N bit) coinciding with a same set of input analog values;
i) since after phase h) the two A/D converters behave as they were equal, repetition of phases a) through e).

In general terms, the procedure of the invention is defined as a linearization procedure of the transfer characteristic of an analog-to-digital converter without requiring the generation of appropriate "training" signals employing a first and a second converter of the same type converting a same actual input signal, directly applied to the inputs of both said two converters when having transfer characteristics supposed to be different between them or attenuating the input signal of a given factor before applying it to the input of the second converter if the two converters have transfer characteristics supposed to be equal, respectively generating first and second N bit digital words at the output of said two converters, and including

i) determine third digital words consisting of a given number of bits, higher than the number of bits N of said first and second digital words produced at output by said first and second converters, representing the digital polynomial coefficients of the inverse transfer characteristic of the first converter if the two converters have characteristics supposed to be equal or of both the converters if they have characteristics supposed to be different, and in case of transfer characteristics supposed to be different between them, generate a biunivocal correspondence table between said second digital words and fourth digital words of said given higher number of bits that better represent the set of input analogue values using said third words representing the digital polynomial coefficients of the inverse transfer characteristic of said second converter, making essentially equal between them said fourth words and said first digital words for a same set of input analog values; and as an alternative

ii) apply in real time said inverse transfer characteristic a said first words; or

iii) generate a second biunivocal correspondence table between said first digital words and fifth digital words with number of bits equal to said higher given number of bits that better represent the set of input analog values; and

iv) on line reading of said second table using said first digital words as pointers.

According to the procedure of the present invention digital polynomial coefficients of the inverse transfer characteristic are employed, having higher length (number of bits) than the first digital words coming out from the A/D converter, making in this errors of integral linearity of absolute value lower than a quantization interval corresponding to a least significant bit of the above mentioned first digital words.

Profitably, actual signals are employed also during the calibration phases avoiding the need to generate appropriate training signals. In phase a) the signal is sent to the input of two A/D converters supposed to be identical, or according to phase f) it is sent to the input of two A/D converters of the same type but having transfer characteristic supposed to be different. The resulting advantage is considerable and consists in the possibility to perform periodical re-calibrations of the converter A/D, discontinuing the on-line operation for a sufficiently brief time, avoiding to equip the equipment with a generator of ad hoc training signals (which would be more expensive than the additional A/D converter). This allows compensating in real time additional deviations of linearity that inevitably occur during the operational life of the device, due for instance to aging or thermal drift.

Concerning one of the drawbacks of the background art, that is the impossibility to conciliate the continuous operation with the calibration phase, the procedure of the invention foresees that, according to another embodiment, said phase c) is implicitly made by a non-volatile memory. In fact, from this it results the possibility to continuously perform with reciprocal interdependence the above mentioned calibration phases and on-line operation. To this purpose it is sufficient to employ on-line in phase e) a second table, similar to the first one, which is exchanged with that presently in preparation in phase d), on completion of the same, thus making the procedure adaptive.

A further object of the invention is a correction circuit based on the use of a processor controlled by an execution program of phases a), b) and c), or d), or f) g) , h) and i), of the procedure.

Profitably, in case the processor is a DSP card (Digital Signal Processing) of limited overall dimensions or an integrated circuit FPGA, the same could also be housed in the same equipment employing the A/D converter, thus avoiding to perform unavoidable subsequent calibrations off-site.

Profitably, in embodiment of the invention with adaptive procedure the processor can operate with a lower clock frequency, resulting less expensive and more easy to find on the market. Profitably, the proposed correction circuit solves the linearity problems

highlighted in the introduction and enables the use of an analog-to-digital converter commonly found on the market, and less expensive (even if used in pair), in an application field where, on the contrary, values of the SFDR parameter around 90-100 dBFS and broad band of the input signal are requested.

Brief description of drawings

The invention, together with further objects and advantages thereof, may be understood with reference to the following description, taken in conjunction with the accompanying drawings, in which:

- Figure 1 shows a block diagram of linearization circuit object of the present invention, in a configuration assumed during the calibration phase;
- Figure 2 shows a block diagram of the linearization circuit object of the present invention, in a configuration assumed during the on-line operation;
- Figure 3 and 4a show a block diagram of the linearization circuit object of the present invention, according to the other embodiment in which two memory blocks, RAM1 and RAM2, respectively, alternate each other during the on-line operation and calibration phases;
- Figure 4b shows a block diagram divided into sub-blocks of the LOG block (5), present in Figures 3 and 4a;
- Figure 5a shows a block diagram of the linearization circuit object of the present invention, according to the other embodiment in which the two A/D converters on which it operates, though of the same type, have different transfer characteristics, in a configuration assumed during a first calibration phase;

- Figure 5b shows the same block diagram of Fig. 5a, in a configuration assumed during a first calibration phase, in which however the converter A/D 2 is broken out into two separate blocks;
- Figure 6 shows a block diagram of the linearization circuit object of the present invention, according to the other embodiment in which the two A/D converters on which we operate, though of the same type, have different transfer characteristics, in a configuration assumed after the first calibration phase:

Detailed description of some embodiments of the invention

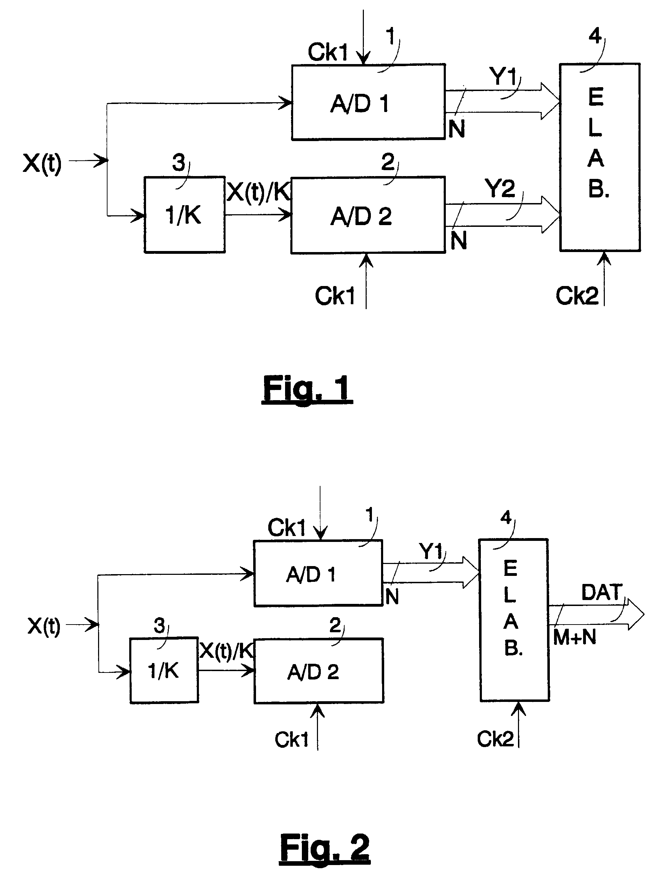

Making reference to Fig. 1, we notice two converters A/D 1 and A/D 2, supposed to be similar, receiving at input an actual signal X(t), directly at the first and attenuated by 1/K (K > 1) through a linear attenuator 3 at the second one, and a clock CK1 and from which N bit digital words come out, placed on two parallel buses Y1 and Y2 that branch towards an electronic processor 4, governed by a clock CK2. Fig. 1 represents the calibration phase of converter A/D 1 essentially made by processor 4; in this phase processor 4 acquires a sufficient minimum number of digital words coming out from converters A/D 1 and A/D 2 and calculates the polynomial coefficients of the inverse transfer characteristic; therefore, no outgoing datum is indicated.

Making reference to Fig. 2, in which the same elements of Fig. 1 are indicated with the same symbols, we notice that the bus Y2 coming out from A/D 2 is no more indicated, since it is no more used. In fact, this figure represents the continuous on-line operation of converter A/D 1, therefore a DAT bus is indicated at output of processor 4, processor that "applies" the polynomial coefficients of the inverse transfer characteristic to data present on the bus Y1, generating the correct codes of the DAT bus.

The operation of the linearization procedure scope of the invention is described below in detail, both in the calibration phase and in the on-line one, making reference to Figures 1 and 2.

The signal X(t) of the example, is an actual signal, typical of the particular recent applications highlighted in the mobile telecommunication sector. The analog-to-digital conversion operation of the X(t) signal can be represented by two blocks in cascade: the first one performs an uncoupling and sampling function, the second one performs a quantization and representation in a digital word. The first block introduces non-linearity in the input-output transfer characteristic H(X(t)), which can be expressed in polynomial mode:

$$Y_i(t) = \alpha_0 + \alpha_1 X_i(t) + \alpha_2 X_i(t)^2 + \alpha_3 X_i(t)^3 + ... + \alpha_n X_i(t)^n = H(X_i(t)) \tag{1}$$

where $Y_i$ is the digital signal coming out from the A/D converter coinciding with the i-th sample of the input signal X(t). The (1) can also be written in such a way as to represent a polynomial model of the output-input transfer characteristic $H^{-1}(Y(t))$:

$$X_i(t) = a_0 + a_1 Y_i(t) + a_2 Y_i(t)^2 + a_3 Y_i(t)^3 + ... + a_n Y_i(t)^n = H^{-1}(Y_i(t)) \tag{2}$$

Making reference to Fig. 1, for a given sampled signal $X_i(t)$, we obtain two output digital words from the two A/D converters, present on buses Y1 and Y2, which can be represented with the following polynomials:

$$X_i(t) = a_0 + a_1 Y_{1,i}(t) + a_2 Y_{1,i}(t)^2 + a_3 Y_{1,i}(t)^3 + ... + a_n Y_{1,i}(t)^n \tag{3}$$

$$X_i(t)/K = a_0 + a_1 Y_{2,i}(t) + a_2 Y_{2,i}(t)^2 + a_3 Y_{2,i}(t)^3 + ... + a_n Y_{2,i}(t)^n \tag{4}$$

Equalizing the (3) and the (4), we obtain the following equation:

$$a_0(1-K) + a_1(Y_{1,i} - K Y_{2,i}) + a_2(Y_{1,i}^2 - K Y_{2,i}^2) + ... + a_n(Y_{1,i}^n - K Y_{2,i}^n) = 0 \tag{5}$$

which contains the unknown coefficients $a_0, a_1, a_2, ... a_n$.

Employing a set of n appropriate different samples of the input signal it is possible to write a number of equations equal to the number of unknown values, in order to have a system that can be solved in $a_0, a_1, a_2, ... a_n$:

$$a_0(1-K) + a_1(Y_{1,1} - K Y_{2,1}) + a_2(Y_{1,1}^2 - K Y_{2,1}^2) + ... + a_n(Y_{1,1}^n - K Y_{2,1}^n) = 0 \tag{6}$$

$$a_0(1-K) + a_1(Y_{1,2} - K Y_{2,2}) + a_2(Y_{1,2}^2 - K Y_{2,2}^2) + ... + a_n(Y_{1,2}^n - K Y_{2,2}^n) = 0$$

$$a_0(1-K) + a_1(Y_{1,3} - K Y_{2,3}) + a_2(Y_{1,3}^2 - K Y_{2,3}^2) + ... + a_n(Y_{1,3}^n - K Y_{2,3}^n) = 0 ...$$

$$a_0(1-K) + a_1(Y_{1,n} - K Y_{2,n}) + a_2(Y_{1,n}^2 - K Y_{2,n}^2) + ... + a_n(Y_{1,n}^n - K Y_{2,n}^n) = 0$$

It is assumed now that the $a_1$ coefficient, called gain coefficient, is known and equal to 1. This assumption does not restrict the linearization method object of the invention, since a possible gain error does not affect the linearity performances of the A/D converter, as it will result clear to those skilled in the art. The system (6) can now be expressed as:

$$-(Y_{1,1} - K Y_{2,1}) = a_0(1-K) + a_2(Y_{1,1}^2 - K Y_{2,1}^2) + ... + a_n(Y_{1,1}^n - K Y_{2,1}^n) \tag{7}$$

$$-(Y_{1,2} - K Y_{2,2}) = a_0(1-K) + a_2(Y_{1,2}^2 - K Y_{2,2}^2) + ... + a_n(Y_{1,2}^n - K Y_{2,2}^n)$$

$$-(Y_{1,3} - K Y_{2,3}) = a_0(1-K) + a_2(Y_{1,3}^2 - K Y_{2,3}^2) + ... + a_n(Y_{1,3}^n - K Y_{2,3}^n) ...$$

$$-(Y_{1,n} - K Y_{2,n}) = a_0(1-K) + a_2(Y_{1,n}^2 - K Y_{2,n}^2) + ... + a_n(Y_{1,n}^n - K Y_{2,n}^n)$$

where the side on the right of the equal sign is known. The system (7) can be represented in a matrix form:

$$N = A*Y \tag{8}$$

where N is the vector of known terms, Y the matrix of known outputs and A the vector of $a_i$ polynomial coefficients. The resolution of the system (8) in A (A = INV(Y)*N ) can be led again to a known theory, based on the matrix inversion, through triangular break out of a square matrix. This technique enables to resolve linear systems, with the advantage that a triangular set of equations in far less difficult in terms of elementary operations to solve (sums and additions) and therefore it can be more easily implemented through a DSP or an FPGA.

On completion of this processing that represents the phase b) of the linearization procedure scope of the invention, vector A is available, containing the polynomial coefficients of the output-input transfer characteristic $H^{-1}(Y(t))$ (that is inverse) of the A/D converter (which are implicitly written in a memory register of the processor).

The choice of the appropriate input n samples, necessary for the application of the proposed linearization procedure, forms part of the invention. The dynamic range of the A/D converter, included between 0 and FS (Full Scale), is subdivided into n separate bands, not overlapped. At the output of the converter n digital words having N bits are taken, which correspond to n separate samples of the signal each one belonging to only one of the n bands.

However, the selection of a single n-pla of samples, is not sufficient to determine with adequate accuracy the $a_i$ coefficients. In the case considered in Fig. 1 the acquisition of h n-uple, each one of them consisting of input samples taken in a random way inside each one of the n bands, enables to obtain h vectors A of $a_i$ coefficients. Operating on these last, an arithmetic mean according to the formula:

$$A_M = (A_1 + A_2 + A_3 + ... + A_h)/h \tag{9}$$

it is possible to determine with higher precision the coefficients and represent them with a number M+N of bits. In conclusion, with this measure, it is used a redundant information to obtain a higher accuracy. Of course, the accuracy with which the $a_i$ are calculated through the (9) is as higher as higher is the number of samples acquired. The time required to complete the calibration phase depends both on the number of samples necessary to obtain values of the $a_i$ coefficients with the desired accuracy and on the maximum allowed frequency for the clock CK2, which scans the single operations of the processor 4. This last shall also be compatible with the conversion speed of A/D 1 during the on-line operation. Therefore, it is necessary to find a compromise between processing time and accuracy; in any case, CK2 shall have frequency higher than the conversion frequency of A/D 1, that is of CK1, since it must perform in real time some sum and multiplication operations in a time lower than the period defined by CK1.

Making reference to Fig. 2, according to the above mentioned phase c), the processor applies in real time to the A/D converter 1 output signal (generated in response to an actual input signal X(t)) the transfer characteristic $H^{-1}(Y(t))$, determined with the configuration of Fig. 1. The global effect is a cancellation of the original non-linearities, with an accuracy depending on the minimum number M of additional bits. The determination of M depends of course on the accuracy degree one wants to reach and, therefore, on the specific requests for the SFDR parameter.

The procedure described above, object of the invention, departs in an original way from the "Threshold Tracking" algorithm. An advantage that is worth to well highlight in comparison with said known art is that to be able to take correction actions with much higher precision. In fact, the method described enables some corrections of the transfer characteristic of the real A/D converter equal to 1 least significant bit of a M+N bit word; that is $2^{-M}$ times more fine of the minimum error that can be obtained according to the "Threshold Tracking" or other known methods.

In the case of special competence of the applicant, the values of N and M are 12 and 4 bits respectively, the polynomial degree is equal to 5 and the number of samples higher than 20000. These values enable to reach the specific requests for the SFDR parameter.

As an alternative to what described in phase c), it is possible to proceed as indicated under points d) and e), foreseeing the generation of a biunivocal correspondence table between the $2^N$ N bit digital words coming out from the converter and the $2^N$ digital words corrected at M+N bits, obtained through the polynomial coefficients $a_i$.

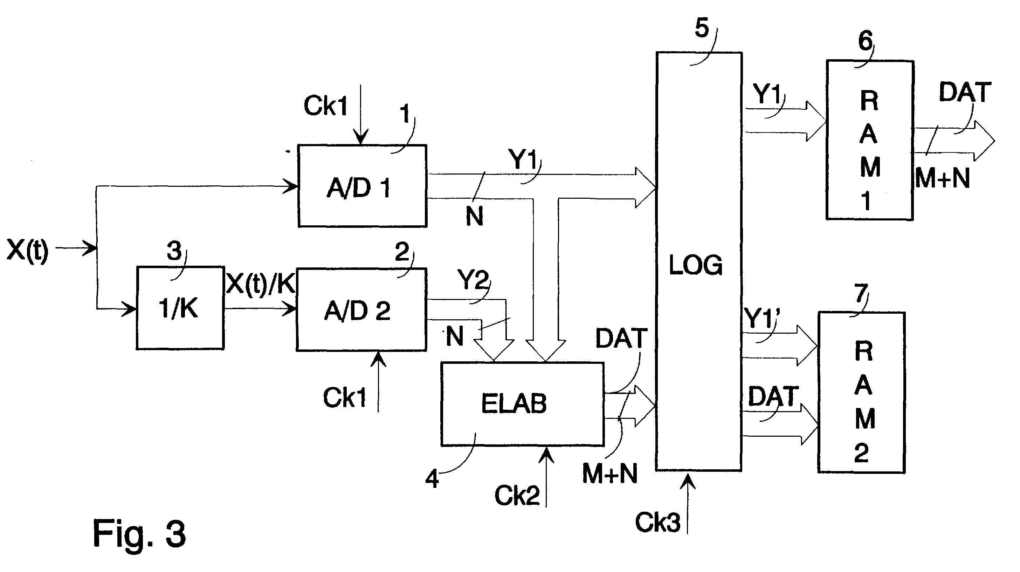

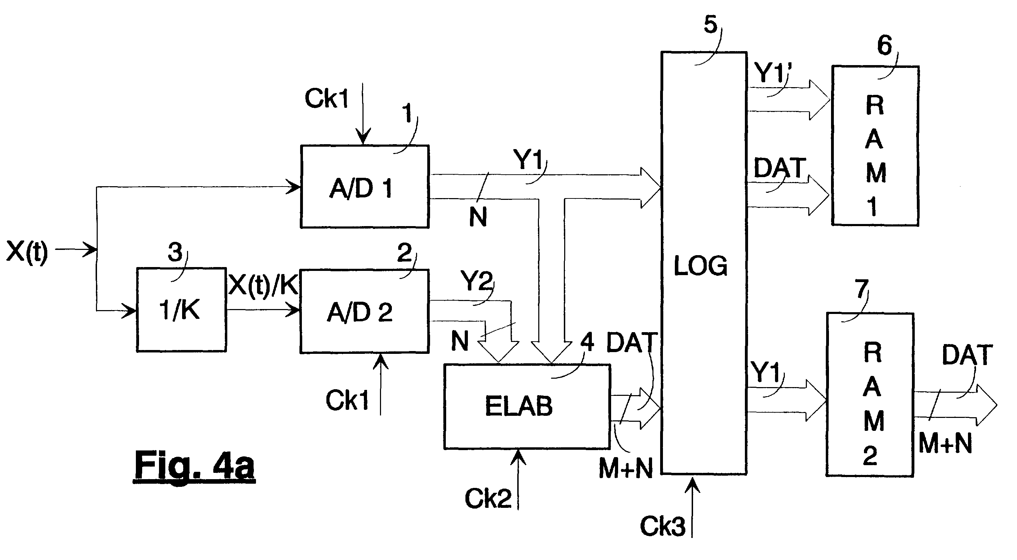

Making reference to Figures 3 and 4a, in which the same elements of the previous figures are indicated with the same symbols, another embodiment of the linearization circuit of Figures 1 and 2 is now described, enabling the adaptive operation.

In Fig. 3 it can be noticed a configuration similar to that of Fig. 1, where the bus Y1 conveys the N bit digital words also towards a first input of a logic unit LOG 5. Furthermore, from the electronic processor 4 comes out a DAT bus, which conveys the M+N bit digital words towards a second input of the logic unit 5. This last has three outputs, two of them for the bus Y1 and one replica Y1' of the same, respectively and a third one for the DAT bus. The replica Y1' is kept in a memory register inside LOG for all the time required by the processor 4 to generate the DAT words. The buses Y1 and Y1' at the first two outputs reach the address inputs of two relevant memories RAM 6 and 7; the DAT bus, in the operation condition shown in Fig. 3, in which the RAM 7 is only written and RAM 6 only read, reaches the data input of the sole memory 7.

Fig. 4a differs from figure 3 only in that, concerning the two RAM 6 and 7, writing operations are alternated to reading ones; logic 5 operates to this purpose, to the detail of which the appropriate figure 4b is dedicated, whose realization can be commonly implemented by those skilled in the art, after the mention to the relevant operation made below.

The diagram in Fig. 4a performs again the phases a) and b), obtaining through the electronic processor 4 the M+N bit $a_i$ coefficients that unambiguously determine the transfer characteristic $H^{-1}(Y(t))$. The latter are used to generate the correct M+N bit digital words, calculated through the equation (2) and stored in the RAM 7 through the DAT bus. The processing made in phase d) is equivalent to a mapping of the set of codes generated by the converter A/D 1 within a second set of linearized codes, written in memory 7.

The logic unit 5 controls the adaptive operation of the linearization circuit shown in Figures 3 and 4a. Firstly, once the calculation phase of $a_i$ coefficients is completed, it performs the synchronization of the words coming out from the first A/D converter 1 (bus Y1') and from the processor 4 (bus DAT). The two N and M+N bit words previously synchronized, are used to write a Look-Up Table in the other one of the two RAM 7, or 6, presently off-line; more in particular the N bit word is used as address for the writing position of the M+N bit word. This single updating operation, also called mapping, applies to all the pairs of synchronized words. The clock CK2 governing the processor 4 shall not necessarily have frequency higher than the conversion frequency of A/D 1, that is of CK1, since the digital word on the address bus Y1' remains for all the time necessary to perform the sum and multiplication operations by the processor 4. Finally, the logic unit 5 connects the bus Y1 to the data input of RAM 6, or 7.

The duration of the writing phase of a RAM is timed by an updating clock whose frequency, obtained through division by one of the clocks present in the circuit, is determined with statistical criteria that shall be described in short. On intervention of the above-mentioned clock, the role of the two RAM is exchanged and the content of the RAM up to that moment read on-line is now updated through a new writing phase.

The means enabling this exchange of roles are selector switches, or multiplexers and demultiplexers, controlled by the updating clock, and are shown in Fig. 4b. More in particular, in the writing phase:

- a first demultiplexer connects the DAT bus to the input of either one or the other of memories 7, or 6;
- a second demultiplexer connects the bus Y1' to the address input of either one or the other of memories 7, or 6;
- a third demultiplexer sends a writing-enabling signal to the one or to the other memory. On the contrary, in the reading phase:
- a fourth demultiplexer connects the bus Y1 to the address input of either one or the other of memories 6, or 7;
- a fifth multiplexer connects the DAT bus of data coming out from one or from the other of the above mentioned memories to user circuits placed downstream, not represented in any figure;

• a sixth demultiplexer sends a reading-enabling signal to one or to the other memory;

• a seventh latch keeps in memory the words Y1 for all the time necessary (Y1' represents the stored replica of Y1).

The selection signals (S1-S7) of multiplexers, demultiplexers and latches are obtained by CK3 through an appropriate circuit whose implementation, not shown in the in figure, results within the range of sector technician.

Since the recovery of distortions introduced by the aging and thermal drift does not involve very stringent real time requirements, the duration of the updating cycle of RAM 6, or 7, essentially depends on the maximum allowed frequency for CK2 and on the dynamic of the actual signal X(t). This last limit is determined by the need to complete the Look-Up Table stored in the RAM, in all its $2^N$ positions. Therefore, the determination of the clock frequency alternating the reading/writing phases in the two RAM 6 and 7 requires also the statistical evaluation of the time variability of the levels of the actual signal X(t). Consequently the period of said updating clock is a random variable depending on the cumulative probability of the distribution of the amplitude of the actual signal X(t), evaluated at the output of the two converters A/D 1 and A/D 2. The pre-set confidence interval must be very wide, close to 99%, to avoid that some code is not updated for more consecutive cycles.

This implementation solution shows the undoubted advantage to enable a calculation phase of correct codes (through equation (2)) and storing in the RAM off-line completely independent from the conversion rate of A/D 1. Therefore, for the clock CK2 there is only the limit to have a frequency equal to CK1 in the samples acquisition phase. This enables to use an electronic processor (anyhow it is realized) with lower speed performances and therefore less expensive and easy-to-find on the market.

A further improvement can be obtained assigning to processor 4 also the task to generate the $2^N$ digital codes having N bits 000...00 to 111...11, which the inverse transfer characteristic is applied to and to store in the RAM. In this way, the filling in phase (writing) of the off-line memory is completely independent also from the acquisition of input samples, allowing the processor 4 to actually operate off line and therefore with clock frequency CK2, that can be much lower than CK1 (with cost saving). Moreover, the period of the updating clock is no more a statistical variable, but depends only on the frequency of clock CK2.

The adaptive version of the linearization procedure, scope of the invention, while allowing correction interventions with accuracy equal to what proposed in the patent by G. Gazzoli and U. Gatti mentioned above, however enables to conciliate the on-line operation with the calibration phase, without the need of availing of additional devices (like a second converter, slow but very accurate and, above all a quick track-and-hold having high SFDR performances, not available on the market), but only requiring two converters of the same type and a very linear and low cost attenuator easy to find on the market.

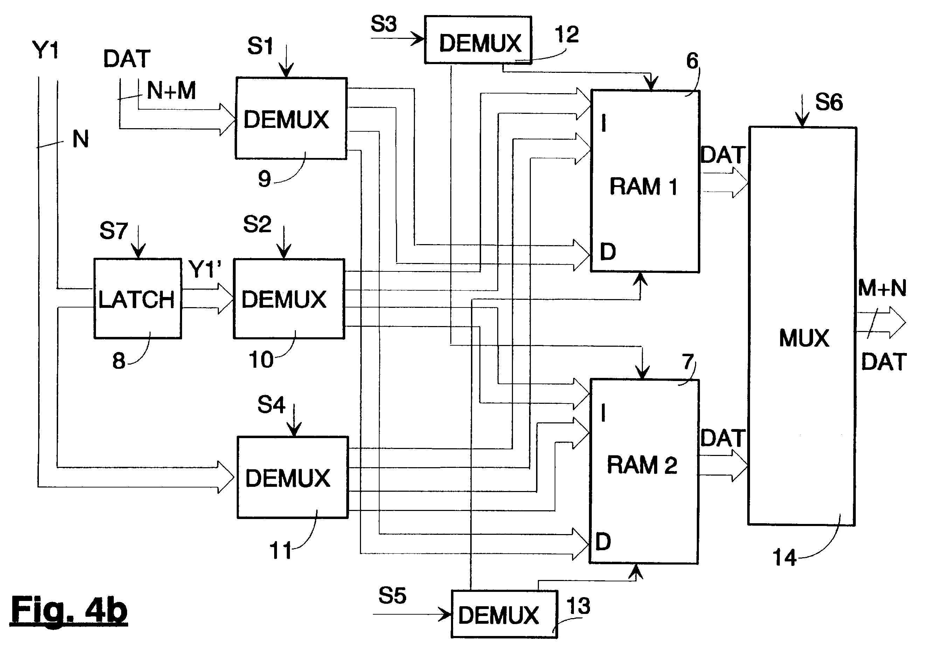

Making reference to Fig. 5a, in which the same elements of Fig. 1 are indicated with the same symbols, a second method of the realization of the linearization procedure, object of the invention is described. In this case, we notice that the actual signal X(t) directly reaches the input of both the converters A/D 1 and A/D 2, supposed to be of the same type, but having different transfer characteristic. Therefore, notwithstanding the absence of the attenuator on one of the two input paths, the output codes of the two converters conveyed by bus Y1 and Y2 are different, even if relating to the same input sample. Fig. 5b shows a different representation of the blocks present in Fig. 5a. In fact, in the same figure the converter A/D 2 is broken down into two separate blocks, out of which the first one represents a converter A/D 3 identical to A/D 1, while the second one, DIFF 5, contains a transfer function, identifying the deviation of the transfer characteristic of A/D 2 versus that of A/D 1. It must be noticed that the output bus from A/D 3, Y1, coincides with that coming out from A/D 1. Both the Y1 and Y2 bus are conveyed to the electronic processor 4. The electronic processor 4, though denoted with the same symbol of Fig. 1, performs now a different function. Since in the first calibration phase it calculates the coefficients of the transfer function DIFF 5 identifying the deviation between A/D 1 and A/D 2, no outgoing datum is indicated.

Making reference to Fig. 5b, for a given sampled signal $X_i(t)$, similarly to what already described, it is possible to represent in polynomial manner the output-input transfer characteristic of DIFF 5:

$$Y_{1,i}(t) = b_0 + b_1 Y_{2,i}(t) + b_2 Y_{2,i}(t)^2 + b_3 Y_{2,i}(t)^3 + ... + b_n Y_{2,i}(t)^n \tag{10}$$

with the unknown coefficients $b_0, b_1, b_2, ... b_n$.

Employing a set of n appropriate different samples of the input signal it is possible to write a number of equations equal to the number of unknown values, so to have a system that can be solved in $b_0, b_1, b_2, ... b_n$. With the known techniques of solution of the linear systems through breakout into triangular matrixes, it is possible to find the vector B of the coefficients that "applied" by the processor 4 in real time or stored in a RAM placed downstream the converter A/D 2 allow to correct the deviation of the transfer characteristic of A/D 2 versus that of A/D 1. Availing again of a redundant information, said coefficients are calculated with higher accuracy and are represented with M+N bits. This completes the phase f), g) and h).

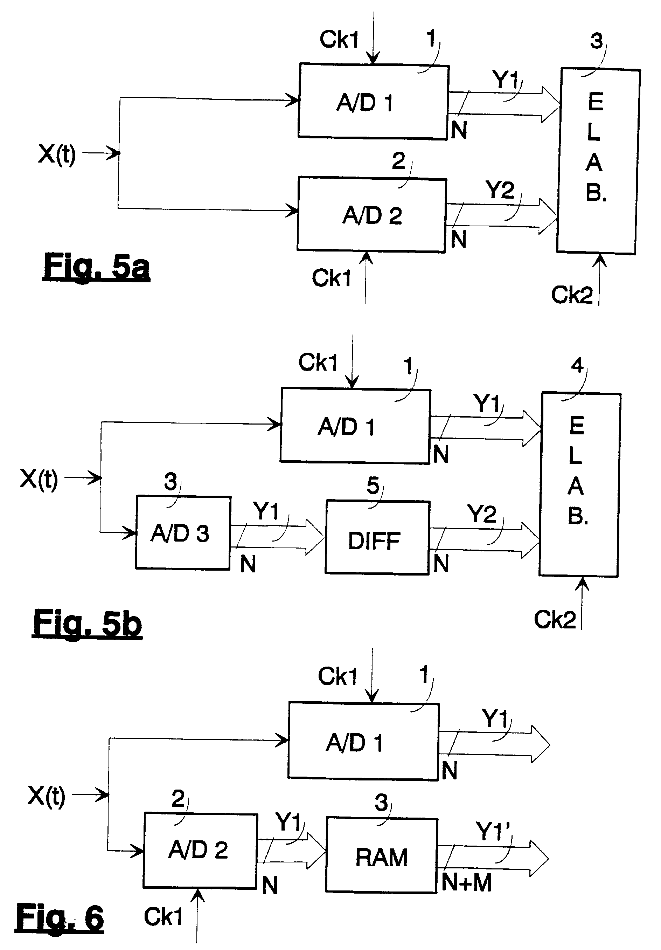

Fig. 6 contains one of the two possible implementations of the correction of deviations, through a RAM 3. The latter implements a biunivocal correspondence between the $2^N$ N bit digital words coming out from the converter A/D 2 and the $2^N$ digital words corrected at M+N bits, obtained through the polynomial coefficients $b_i$. Now, it is as if we avail of two converters with virtually equal transfer characteristic, therefore from A/D 1 and from RAM 3 come out two code buses Y1 and Y1', which though represented at N and M+N bits respectively, are identical.

At the end of this first calibration phase, we avail therefore of two virtually equal conversion paths, to which the correction procedure, scope of the invention, can be applied according to the first method. In practice, the procedure outlined in phases a), b), c), or d), and e) has to be applied. The sole change is that at the phase starting in section h) each M+N bit word coming out from the A/D converter 2 is truncated at N bit, so that both Y1 and Y1' convey N bit words.

Of course, it is possible to apply the variant of adaptive memories described above, also to this second method of linearization procedure.

Therefore, while some particular preferred embodiments of the present invention have been shown and described, it should be understood that the present invention is not limited thereto since other embodiments may be made by those skilled in the art without departing from the scope thereof.

**Claims**

1. Linearization procedure of the transfer characteristic of an analog-to-digital converter without requiring the generation of appropriate "training" signals employing a first and a second converter of the same type converting a same actual input signal, directly applied to the inputs of both said converters if having transfer characteristics supposed to be different between them or attenuating the input signal of a given factor before applying the same to the input of the second converter if the two converters have transfer characteristics supposed to be equal, generating first and second N bit digital words, respectively, coming out from said two converters, and including

   i) determine third digital words consisting of a given number of bits, higher than the number of bits N of said first and second digital words produced at output from said first and second converters, representing the digital polynomial coefficients of the inverse transfer characteristic of the first converter if the two converters have characteristics supposed to be equal or of both the converters if they have characteristics supposed to be different, and in case of transfer characteristics supposed to be different between them, generate a bi-univocal correspondence table between said second digital words and fourth digital words of said given higher number of bits better representing the set of analogue input values using said third words representing the digital polynomial coefficients of the inverse transfer characteristic of said second converter, making essentially equal said fourth words and said first digital words for a same set of input analogue values; and as an alternative
   ii) apply in real time said inverse transfer characteristic to said first word; or
   iii) generate a second biunivocal correspondence table among said first digital words and fifth digital words with bit number equal to said given higher number of bits that better represent the set of input analogue values; and
   iv) read on-line said second table, using said first digital words as pointers.

2. Procedure according to claim 1, characterized in that it foresees also the following phases:

   • Divide the dynamic range of converters into n separate and not overlapped bands;
   • determine said first and second digital words having N bits starting from a n-ple of input samples.

3. Procedure according to claims 1 and 2, characterized in that said first and second N bit-digital words are determined starting from h n-uple of input samples.

4. Procedure according to claim 3, characterized in that said h n-uple of input samples are randomly taken inside each one of the n bands in order to obtain h A vectors of $a_i$ coefficients, operating on the latter an arithmetic mean according to the formula:

$$A_M = (A_1 + A_2 + A_3 + ... + A_h)/h$$

5. Procedure according to claim 1, in which the application of the inverse transfer characteristic to said first words coming out from said first converter (ii) is made in real time employing a non volatile memory and the on-line reading of said second table (iv) is made employing a third table which is exchanged with said second table on completion of one of its updating regeneration (iii), making the linearization procedure adaptive and usable in "on line" mode without discontinuing the operation of the analog-to-digital converter.

6. Analog-to-digital converter that can be linearized without requesting the generation of appropriate "training" signals including a first (1) and a second (2) analog-to-digital converter of the same type, both converting a same actual input signal (X(t)), directly applied to the inputs of both said two converters if having transfer characteristics supposed to be different between them or attenuating the input signal (X(t)/K) through a linear attenuator (3) placed upstream the input of the second converter (2) if the two converters have transfer characteristics supposed to be equal, a logic processing unit (4) calculating the digital polynomial coefficients with number of bits higher than the number of bits of the digital words forming said input signal of the inverse transfer characteristic of the first converter (1), if the two converters have characteristics supposed to be equal, or of both the converters (1, 2), if having characteristics supposed to be different, generating a bi-univocal correspondence table between said second digital words and fourth digital words of said higher given number of bits that better represent the aggregate of input analogue values employing said third words representing the digital polynomial coefficients of the inverse transfer characteristic of said second converter (2), making essentially equal among them said fourth words and said first digital words for a same group of input analogue values and, as an alternative

combining said digital polynomial coefficients of the inverse characteristic of the first converter (1) to the data present on the bus (Y1) at the output of said first converter (1) generating correct codes on the output bus (DAT) in a continuous on-line operation phase; or
generating a second bi-univocal correspondence table between said first digital words and fifth digital words with number of bits equal to said higher given number of bits that better represent the set of input analog values, in a linearization phase.

7. Analog-to-digital converter with linearization possibility according to claim 6, characterized in that it includes also:

a second logic processing unit (5) receiving the data present on said bus (Y1) and said correct codes present on the output bus (DAT) of said first logic processing unit (4);
said second logic unit (5) producing three output flows on relevant output buses of the data of the input bus (Y1) and of one replica (Y1') of the same, respectively, temporarily stored in a latch (8) and of data present on said input bus (DAT);
a first RAM (6) and a second RAM (7), said second logic unit (5) alternatively determining the writing of one or the other of said RAM (6, 7) in a linearization step and the reading of the other RAM, written in a previous linearization step, enabling the continuous on-line of the converter.

8. The converter according to claim 7, characterized in that said latch (8) stores the data of said first bus (Y1) and supplies at output a replica data flow (Y1') delayed by the time necessary to said first logic processing unit (4) to calculate said third digital words (DAT), and said second logic processing unit (5) includes:

three multiplexers (9, 10, 11) respectively transferring the data of said output bus (DAT) from said first logic processing unit (4), said replica data delayed (Y1') and the data of said first bus (Y1), selectively at the input of said first RAM (6) or of said second RAM (7) through a same number of logic controls (S1, S2, S4);
two demultiplexers (12, 13) for reading or writing command of said first RAM (6) and of said second RAM (7) and an output multiplexer (14) selecting data read by said first RAM (6) or by said second RAM (7), controlled by a same number of logic controls (S3, S5, S6).

**Fig. 1**

**Fig. 2**

Fig. 3

**Fig. 4a**

14

**Fig. 4b**

EP 1 061 652 A2

**Fig. 5a**

**Fig. 5b**

**Fig. 6**